# EUROPEAN PATENT APPLICATION

(11) **EP 4 654 792 A1**
(43) Date of publication of application: **26.11.2025**
(21) Application number: 24766211.7
(22) Date of filing: 22.01.2024
(51) Int. Cl.: H10K 30/50

(54) **PEROVSKITE BATTERY, PREPARATION METHOD AND CORRESPONDING ELECTRIC DEVICE**

(30) Priority: 06.03.2023 CN 202310201482
(71) Applicant: Contemporary Amperex Technology Co., Limited, Ningde, Fujian 352100 (CN)
(72) Inventor: SU, Shuojian, Ningde, Fujian 352100 (CN); LIN, Xiangling, Ningde, Fujian 352100 (CN); LI, Hanfang, Ningde, Fujian 352100 (CN); ZHANG, Fan, Ningde, Fujian 352100 (CN); CHEN, Guodong, Ningde, Fujian 352100 (CN); GUO, Yongsheng, Ningde, Fujian 352100 (CN)
(74) Representative: Lorenz Seidler Gossel Part. mbB
(86) International application number: PCT/CN2024/073493
(87) International publication number: WO 2024/183488

(57) **Abstract**

This application relates to a perovskite battery, a preparation method thereof, and a corresponding electric apparatus, where the perovskite battery includes a first electrode, a hole transport layer, a perovskite layer, an electron transport layer, and a second electrode that are arranged sequentially, where the hole transport layer includes a body layer and a surface layer disposed on a side of the body layer close to the perovskite layer; the hole transport layer includes nickel oxide containing trivalent nickel ions; and an atomic percentage of trivalent nickel ions in the surface layer is less than an atomic percentage of trivalent nickel ions in the body layer. This application further relates to a corresponding preparation method and electric apparatus.

## Description

### CROSS-REFERENCE TO RELATED APPLICATIONS

This application incorporates by reference in its entirety Chinese Patent Application No. 202310201482.6, filed on March 6, 2023 and entitled "PEROVSKITE BATTERY, PREPARATION METHOD THEREOF, AND CORRESPONDING ELECTRIC APPARATUS".

### TECHNICAL FIELD

This application relates to the field of perovskite batteries, and in particular, to a perovskite battery, a preparation method thereof, and a corresponding electric apparatus.

### BACKGROUND

With rapid development of the field of new energy, solar cells have been widely applied in fields such as military, aerospace, industry, commerce, agriculture, and communication. Due to advantages of perovskite batteries, such as high photoelectric conversion efficiency, simple preparation processes, low production costs, and low material costs, the perovskite batteries have gradually become a research hotspot of next-generation solar cells.

Nickel oxide, as an inorganic hole transport layer material most commonly used in inverted perovskite batteries, is a preferred candidate for industrialization of perovskite batteries. However, trivalent nickel on a surface of a nickel oxide hole transport layer reacts with A-site cations and X-site halogens in a perovskite precursor solution, thereby deteriorating photoelectric conversion efficiency of a perovskite battery. In addition, erosion of a perovskite light-absorbing layer by water and oxygen affects stability of the perovskite battery to some extent. Therefore, a structure or performance of a conventional perovskite battery still requires improvement.

### SUMMARY

This application is made in view of the above issue, and aims to provide a perovskite battery that enhances stability of a perovskite layer while ensuring conductivity of a nickel oxide hole transport layer, thereby improving photoelectric conversion efficiency of the battery. In addition, a preparation method of the perovskite battery has lower costs and is simple to operate.

To achieve the above objective, this application provides a perovskite battery, a preparation method thereof, and an electric apparatus.

A first aspect of this application provides a perovskite battery, including a first electrode, a hole transport layer, a perovskite layer, an electron transport layer, and a second electrode that are arranged sequentially, where the hole transport layer includes a body layer and a surface layer disposed on a side of the body layer close to the perovskite layer; the hole transport layer includes nickel oxide containing trivalent nickel ions; and an atomic percentage of trivalent nickel ions in the surface layer is less than an atomic percentage of trivalent nickel ions in the body layer.

According to the perovskite battery of this application, the atomic percentage of the trivalent nickel ions in the surface layer disposed on the side of the body layer close to the perovskite layer is reduced, so as to reduce reaction between the trivalent nickel ions and perovskite in the perovskite layer, thereby enhancing stability of the perovskite layer. In addition, conductivity of the hole transport layer containing nickel oxide is ensured, thereby improving photoelectric conversion efficiency of the battery.

In any embodiment of this application, the atomic percentage of the trivalent nickel ions in the surface layer decreases in a gradient manner along a thickness direction of the surface layer from a side close to the body layer to a side away from the body layer. This further enhances stability of the perovskite layer while ensuring conductivity, thereby improving photoelectric conversion efficiency of the battery.

In any embodiment of this application, the atomic percentage of the trivalent nickel ions decreases along the thickness direction of the surface layer with a gradient of 0.5-4 nm. This further enhances stability of the perovskite layer while ensuring conductivity, thereby improving photoelectric conversion efficiency of the battery.

In any embodiment of this application, a difference between atomic percentages of trivalent nickel ions in two adjacent gradients is 2-20%. This further enhances stability of the perovskite layer while ensuring conductivity, thereby improving photoelectric conversion efficiency of the battery.

In any embodiment of this application, an atomic percentage of trivalent nickel ions in an outermost gradient of the surface layer in direct contact with the perovskite layer is 1-15%. This further enhances stability of the perovskite layer while ensuring conductivity, thereby improving photoelectric conversion efficiency of the battery.

In any embodiment of this application, the atomic percentage of the trivalent nickel ions in the body layer is 20-65%. This further enhances stability of the perovskite layer while ensuring conductivity, thereby improving photoelectric conversion efficiency of the battery.

In any embodiment of this application, a thickness of the surface layer is 2-15 nm; and/or a thickness of the body layer is 10-40 nm. This further enhances stability of the perovskite layer while ensuring conductivity, thereby improving photoelectric conversion efficiency of the battery.

A second aspect of this application provides a method for preparing a perovskite battery, including:
(1) providing a first electrode;
(2) preparing a hole transport layer on the first electrode;
(3) preparing a perovskite layer on the hole transport layer;
(4) preparing an electron transport layer on the perovskite layer; and
(5) preparing a second electrode on the electron transport layer to obtain the perovskite battery,
where the hole transport layer includes a body layer and a surface layer disposed on a side of the body layer close to the perovskite layer; the hole transport layer includes nickel oxide containing trivalent nickel ions; and an atomic percentage of trivalent nickel ions in the surface layer is less than an atomic percentage of trivalent nickel ions in the body layer.

The method of this application has lower costs and is simple to operate, thereby facilitating large-scale industrial application.

In any embodiment of this application, step (2) includes preparing the hole transport layer on the first electrode according to a magnetron sputtering method using a nickel oxide target material. Therefore, the perovskite battery according to the first aspect of this application can be prepared more simply.

In any embodiment of this application, a condition of the magnetron sputtering method includes: an argon-to-oxygen ratio used during preparation of the body layer being 500:(1-200). Therefore, the perovskite battery according to the first aspect of this application can be prepared more simply.

In any embodiment of this application, the condition of the magnetron sputtering method includes: an argon-to-oxygen ratio used during preparation of the surface layer being higher than the argon-to-oxygen ratio used during preparation of the body layer. Therefore, the perovskite battery according to the first aspect of this application can be prepared more simply.

A third aspect of this application provides an electric apparatus, including the perovskite battery according to the first aspect of this application, or a perovskite battery prepared according to the method according to the second aspect of this application, where the perovskite battery is used to supply power to the electric apparatus.

According to the perovskite battery of this application, the atomic percentage of the trivalent nickel ions in the surface layer disposed on the side of the body layer close to the perovskite layer is reduced, so as to reduce reaction between the trivalent nickel ions and perovskite in the perovskite layer. In addition, conductivity of the hole transport layer containing nickel oxide is ensured, thereby improving photoelectric conversion efficiency of the battery.

### DESCRIPTION OF DRAWINGS

To describe technical solutions of embodiments of this application more clearly, an accompanying drawing required for describing the embodiments of this application is briefly described below. Apparently, the accompanying drawing described below is merely an embodiment of this application, and a person of ordinary skill in the art may obtain other drawings based on this accompanying drawing without creative efforts. In the accompanying drawing:

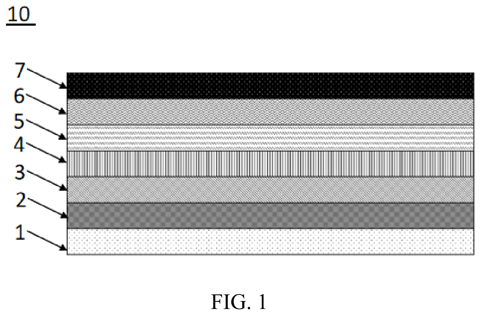

FIG. 1 shows a schematic diagram of a structure of a perovskite battery according to an embodiment of this application.

Reference numerals are described as follows:
1. FTO; 2. nickel oxide body layer; 3. nickel oxide surface layer; 4. perovskite layer; 5. C60; 6. BCP; 7. Cu; and 10. perovskite battery.

### DESCRIPTION OF EMBODIMENTS

Hereinafter, embodiments specifically disclosing a perovskite battery, a preparation method thereof, and a corresponding electric apparatus according to this application are described in detail with appropriate reference to the accompanying drawing. However, unnecessary detailed descriptions may be omitted in some cases. For example, detailed descriptions of well-known matters or repetitive descriptions of actually identical structures may be omitted. This is to prevent the following description from becoming unnecessarily lengthy, so as to help a person skilled in the art have a better understanding. Furthermore, the accompanying drawing and the following description are provided for a person skilled in the art to fully understand this application and are not intended to limit the subject matter recited in the claims.

"Range" disclosed in this application is defined in the form of a lower limit and an upper limit. A given range is defined by selecting one lower limit and one upper limit, where the selected lower and upper limits define boundaries of the special range. Ranges defined in this manner may include or exclude endpoints and may be arbitrarily combined, that is, any lower limit may be combined with any upper limit to form a range. For example, if ranges of 60-120 and 80-110 are listed for a specific parameter, ranges of 60-110 and 80-120 are also contemplated. Additionally, if minimum range values of 1 and 2 are listed, and maximum range values of 3, 4, and 5 are listed, all of the following ranges can be contemplated: 1-3, 1-4, 1-5, 2-3, 2-4, and 2-5. In this application, unless otherwise specified, a numerical range "a-b" represents an abbreviated representation of any combination of real numbers between a and b, where a and b are both real numbers. For example, the numerical range "0-5" means that all real numbers between "0 and 5" have been completely listed herein, and "0-5" is merely an abbreviated representation of combinations of these numbers. In addition, a parameter being expressed as an integer greater than or equal to 2 is equivalent to disclosing that the parameter is, for example, an integer of 2, 3, 4, 5, 6, 7, 8, 9, 10, 11, 12, or the like.

Unless otherwise specified, all embodiments and optional embodiments of this application may be combined with each other to form new technical solutions.

Unless otherwise specified, all technical features and optional technical features of this application may be combined with each other to form new technical solutions.

Unless otherwise specified, all steps of this application may be performed sequentially or randomly, but are preferably performed sequentially. For example, the method including steps (a) and (b) indicates that the method may include steps (a) and (b) that are performed sequentially or may include steps (b) and (a) that are performed sequentially. For example, when it is mentioned that the method may further include step (c), it indicates that step (c) may be added to the method in any order, for example, the method may include steps (a), (b), and (c), or steps (a), (c), and (b), or steps (c), (a), and (b), or the like.

Unless otherwise specified, "include" and "contain" mentioned in this application are inclusive or may be exclusive. For example, "include" and "contain" may indicate that other unlisted components may also be included or contained, or that only the listed components are included or contained.

Unless otherwise specified, in this application, the term "or" is inclusive. For example, the phrase "A or B" indicates "A, B, or both A and B". More specifically, any one of the following conditions satisfies the condition "A or B": A is true (or present) and B is false (or not present); A is false (or not present) and B is true (or present); or both A and B are true (or present).

Nickel oxide, as an inorganic hole transport layer material most commonly used in inverted perovskite batteries, is a preferred candidate for industrialization of perovskite batteries. However, trivalent nickel on a surface of a hole transport layer reacts with A-site cations and X-site halogens in a perovskite precursor solution, thereby deteriorating photoelectric conversion efficiency of a perovskite battery. In addition, erosion of a perovskite light-absorbing layer by water and oxygen affects stability of the perovskite battery to some extent. In the perovskite battery of this application, an interface passivation layer containing nickel oxide (II) is provided between the hole transport layer (particularly, a nickel oxide (NiOₓ) hole transport layer) and the perovskite layer, so that the battery has high photoelectric conversion efficiency and good long-term stability. In addition, a preparation method of the battery has lower costs and is simple to operate.

### Perovskite battery

In some embodiments, a first aspect of this application provides a perovskite battery, including a first electrode, a hole transport layer, a perovskite layer, an electron transport layer, and a second electrode that are arranged sequentially, where the hole transport layer includes a body layer and a surface layer disposed on a side of the body layer close to the perovskite layer; the hole transport layer includes nickel oxide containing trivalent nickel ions; and an atomic percentage of trivalent nickel ions in the surface layer is less than an atomic percentage of trivalent nickel ions in the body layer.

According to the perovskite battery of this application, the atomic percentage of the trivalent nickel ions in the surface layer disposed on the side of the body layer close to the perovskite layer is reduced, so as to reduce reaction between the trivalent nickel ions and perovskite in the perovskite layer, thereby enhancing stability of the perovskite layer. In addition, conductivity of the hole transport layer containing nickel oxide is ensured, thereby improving photoelectric conversion efficiency of the battery.

In some embodiments, the hole transport layer includes nickel oxide containing trivalent nickel ions, where nickel oxide is generally denoted as NiOₓ, and may represent a compound containing oxygen and nickel.

In some embodiments, the hole transport layer is a nickel oxide hole transport layer.

In some embodiments, substances such as NiO, Ni(OH)₂, Ni₂O₃, and NiOOH may be present in the hole transport layer.

In some embodiments, the trivalent nickel ions in the hole transport layer generally exist in forms such as Ni₂O₃ and NiOOH, and divalent nickel ions generally exist in forms such as NiO and Ni(OH)₂.

In some embodiments of this application, the atomic percentage of the trivalent nickel ions in the surface layer decreases in a gradient manner along a thickness direction of the surface layer from a side close to the body layer to a side away from the body layer. This further enhances stability of the perovskite layer while ensuring conductivity, thereby improving photoelectric conversion efficiency of the battery.

The expression "decreases in a gradient manner" means that an atomic percentage of trivalent nickel ions remains constant within one gradient, while an atomic percentage of trivalent nickel ions in another gradient disposed adjacently to a side of the one gradient away from the body layer decreases relative to the atomic percentage of the trivalent nickel ions within the one gradient.

In this application, the unit "nm" refers to nanometer.

In some embodiments of this application, the atomic percentage of the trivalent nickel ions decreases along the thickness direction of the surface layer with a gradient of 0.5-4 nm. This further enhances stability of the perovskite layer while ensuring conductivity, thereby improving photoelectric conversion efficiency of the battery. It may be understood that "0.5-4 nm" means 0.5 nm-4 nm.

In some embodiments, a thickness of 1.5-4 nm is typically used as one gradient along the thickness direction of the surface layer. In other words, a thickness of one gradient is 1.5-4 nm.

In some embodiments, a thickness of 1.5-2.5 nm is typically used as one gradient along the thickness direction of the surface layer. In other words, a thickness of one gradient is 1.5-2.5 nm.

In some embodiments, a quantity of gradients in the surface layer is generally 1-10. The "quantity of gradients" refers to a quantity by which the atomic percentage of the trivalent nickel ions in the surface layer changes with a thickness of the surface layer. Starting from the side close to the body layer, a gradient in the surface layer closest to the body layer is counted as a first gradient; along the thickness direction of the surface layer towards the perovskite layer, gradients are sequentially counted as a second gradient, a third gradient, a fourth gradient, and the like; and a gradient closest to a side of the perovskite layer is referred to as an outermost gradient.

In some embodiments, the quantity of gradients in the surface layer is generally 3-6.

In some embodiments of this application, a difference between atomic percentages of trivalent nickel ions in two adjacent gradients is 2-20%. This further enhances stability of the perovskite layer while ensuring conductivity, thereby improving photoelectric conversion efficiency of the battery. It may be understood that "2-20%" means 2%-20%.

In some embodiments, a difference between atomic percentages of trivalent nickel ions in two adjacent gradients is 2%-10%. This further enhances stability of the perovskite layer while ensuring conductivity, thereby improving photoelectric conversion efficiency of the battery.

In some embodiments, a difference between atomic percentages of trivalent nickel ions in two adjacent gradients is 3.5%-6%. This further enhances stability of the perovskite layer while ensuring conductivity, thereby improving photoelectric conversion efficiency of the battery.

In some embodiments of this application, an atomic percentage of trivalent nickel ions in an outermost gradient of the surface layer in direct contact with the perovskite layer is 1-15%. This further enhances stability of the perovskite layer while ensuring conductivity, thereby improving photoelectric conversion efficiency of the battery.

The "outermost gradient" refers to a gradient in the surface layer of the hole transport layer that is farthest from the body layer. The gradient layer is in direct contact with the perovskite layer. A thickness of the outermost gradient may differ from a thickness of another gradient or may be the same as a thickness of another gradient.

In this application, the "atomic percentage" refers to a percentage of atoms of the ions in atoms of a layer or gradient where the ions are located, and is calculated based on a total quantity of the atoms of the layer or gradient where the ions are located. The quantity of the atoms refers to a quantity of atoms of the ions in the layer or gradient where the ions are located, and is measured via X-ray photoelectron spectroscopy (XPS).

In some embodiments, an atomic percentage of trivalent nickel ions in an outermost gradient of the surface layer in direct contact with the perovskite layer is 1-12%. This further enhances stability of the perovskite layer while ensuring conductivity, thereby improving photoelectric conversion efficiency of the battery.

In some embodiments, an atomic percentage of trivalent nickel ions in an outermost gradient of the surface layer in direct contact with the perovskite layer is 1-10%. This further enhances stability of the perovskite layer while ensuring conductivity, thereby improving photoelectric conversion efficiency of the battery.

In some embodiments, an atomic percentage of trivalent nickel ions in an outermost gradient of the surface layer in direct contact with the perovskite layer is 1-5%. This further enhances stability of the perovskite layer while ensuring conductivity, thereby improving photoelectric conversion efficiency of the battery.

In some embodiments of this application, the atomic percentage of the trivalent nickel ions in the body layer is 20-65%. This further enhances stability of the perovskite layer while ensuring conductivity, thereby improving photoelectric conversion efficiency of the battery.

In some embodiments, the atomic percentage of the trivalent nickel ions in the body layer is 25-40%. This further enhances stability of the perovskite layer while ensuring conductivity, thereby improving photoelectric conversion efficiency of the battery.

In some embodiments, the atomic percentage of the trivalent nickel ions in the body layer is 25-35%. This further enhances stability of the perovskite layer while ensuring conductivity, thereby improving photoelectric conversion efficiency of the battery.

In some embodiments, the atomic percentage of the trivalent nickel ions in the body layer is 28-33%. This further enhances stability of the perovskite layer while ensuring conductivity, thereby improving photoelectric conversion efficiency of the battery.

In some embodiments of this application, a thickness of the surface layer is 2-15 nm; and a thickness of the body layer is 10-40 nm. This further enhances stability of the perovskite layer while ensuring conductivity, thereby improving photoelectric conversion efficiency of the battery.

In some embodiments, a thickness of the surface layer is 2-12 nm.

In some embodiments, a thickness of the surface layer is 8-12 nm.

In some embodiments, a thickness of the body layer is 10-30 nm.

In some embodiments, a thickness of the body layer is 10-15 nm.

In some embodiments, in the body layer, a ratio of a quantity of atoms of the trivalent nickel ions to a quantity of atoms of divalent nickel ions is 1:1.

In some embodiments, a total thickness of the hole transport layer is 12-50 nm.

In some embodiments, a total thickness of the hole transport layer is 12-25 nm.

In some embodiments, a total thickness of the hole transport layer is 18-25 nm.

In some embodiments, the perovskite battery is a regular perovskite battery or an inverted perovskite battery. For example, the perovskite battery is an inverted perovskite battery.

In some embodiments, the first electrode is an anode layer playing a role in collecting holes, and is generally referred to as a transparent electrode.

In some embodiments, the first electrode is selected from at least one of fluorine-doped tin oxide (FTO), indium tin oxide (ITO), aluminum-doped zinc oxide (AZO), boron-doped zinc oxide (BZO), indium zinc oxide (IZO), or indium tungsten oxide (IWO); and a thickness of the first electrode layer is 100-1000 nm, for example, 300-800 nm.

In this application, the unit "cm" refers to centimeter.

In some embodiments, the perovskite battery further includes a transparent substrate layer selected from at least one of transparent glass, polyethylene terephthalate (PET), or a polyimide substrate; and a thickness of the transparent substrate layer is 0. 1-3 cm.

Therefore, in an embodiment of this application, the perovskite battery of this application includes a transparent substrate layer, a first electrode, a nickel oxide hole transport layer, a perovskite layer, an electron transport layer, and a second electrode that are stacked sequentially.

In some embodiments, the perovskite layer is a light-absorbing layer, namely, an active layer of the perovskite battery, composed of a perovskite material. This layer is a core position of an entire battery structure.

In some embodiments, a chemical formula of a material of the perovskite layer is ABX₃ or A₂CDX₆, where A is an inorganic cation, an organic cation, or organic-inorganic mixed cations, including at least one of an organic amine cation, a Cs cation, a K cation, an Rb cation, or a Li cation; and the organic amine cation is selected from (NR1R2R3R4)⁺, (R1R2N=CR3R4)⁺, (R1R2N-C(R5)=NR3R4)⁺, or (R1R2N-C(NR5R6)=R3R4)⁺, where R1, R2, R3, R4, R5, and R6 are each independently selected from H, a substituted or unsubstituted C1-20 alkyl group, or a substituted or unsubstituted aryl group.

In some embodiments, A is at least one of a methylamino group (CH₃NH₃⁺)(MA⁺), a formamidinium group (HC(NH₂)₂⁺)(FA⁺), a cesium ion (Cs⁺), or a rubidium ion (Rb⁺). For example, A is a methylamino group (CH₃NH₃⁺) or a formamidinium group (HC(NH₂)₂⁺).

B is an inorganic cation, an organic cation, or organic-inorganic mixed cations, including at least one of lead, tin, zinc, titanium, antimony, bismuth, nickel, iron, cobalt, silver, copper, gallium, germanium, magnesium, calcium, indium, aluminum, manganese, chromium, molybdenum, or europium. For example, B is at least one of divalent metal ions Pb²⁺ and Sn²⁺.

C is an inorganic cation, an organic cation, or organic-inorganic mixed cations. For example, C is a monovalent metal ion such as Ag⁺.

D is an inorganic cation, an organic cation, or organic-inorganic mixed cations. For example, D is a trivalent metal ion such as a bismuth cation Bi³⁺, an antimony cation Sb³⁺, or an indium cation In³⁺.

X is an inorganic anion, an organic anion, or organic-inorganic mixed anions. For example, X is one or both of a halogen anion or a carboxylate anion. For example, X is a bromide ion (Br⁻) or an iodide ion (I⁻).

In this application, the unit "eV" refers to electron volt.

In some embodiments, a bandgap of the perovskite layer is 1.20 eV-2.30 eV.

In some embodiments, a thickness of the perovskite layer is 200-800 nm.

In some embodiments, a thickness of the perovskite layer is 400-600 nm.

In some embodiments, the perovskite battery further includes an electron transport layer.

In some embodiments, the electron transport layer is used to efficiently transport free electrons generated by the perovskite layer, thereby effectively blocking passage of free holes, and forming ohmic contact at an interface with the perovskite active layer.

In some embodiments, a material of the electron transport layer is at least one of the following materials, derivatives thereof, or materials obtained by performing doping or passivation thereon: [6,6]-phenyl-C₆₁-isobutyl butyrate (PC₆₁BM), [6,6]-phenyl-C₇₁-methyl butyrate (PC₇₁BM), fullerene C60, fullerene C70, cyano-containing poly(phenylene acetylene), a boron-containing polymer, bathocuproine, bathophenanthroline, aluminum hydroxyquinoline, an oxadiazole compound, a benzimidazole compound, a naphthalene tetracarboxylic acid compound, a perylene derivative, a phosphine oxide compound, a phosphine sulfide compound, fluorine-containing phthalocyanine, titanium oxide, zinc oxide, indium oxide, tin oxide, gallium oxide, tin sulfide, indium sulfide, lithium fluoride, sodium fluoride, magnesium fluoride, or zinc sulfide.

In some embodiments, a material of the electron transport layer is at least one of the following materials, derivatives thereof, or materials obtained by performing doping or passivation thereon: [6,6]-phenyl-C₆₁-isobutyl butyrate (PC₆₁BM), [6,6]-phenyl-C₇₁-methyl butyrate (PC₇₁BM), fullerene C60 (C60), fullerene C70 (C70), tin oxide (SnO₂), or zinc oxide (ZnO).

In some embodiments, a thickness of the electron transport layer is 10-200 nm.

In some embodiments, a thickness of the electron transport layer is 30-120 nm.

In some embodiments, a thickness of the electron transport layer is 40-60 nm.

Therefore, in an embodiment of this application, the perovskite battery of this application includes a transparent substrate layer, a first electrode, a nickel oxide hole transport layer, a perovskite layer, an electron transport layer, and a second electrode that are stacked sequentially.

In some embodiments, the second electrode is a cathode layer used to collect free electrons.

In some embodiments, the second electrode is typically an organic, inorganic, or organic-inorganic hybrid conductive material, including at least one of indium tin oxide (ITO), lanthanide-doped indium oxide, boron-doped zinc oxide (BZO), aluminum zinc oxide (AZO), indium zinc oxide (IZO), gallium zinc oxide (GZO), indium tungsten oxide (IWO), Au, Ag, Cu, Al, Ni, Cr, Bi, Pt, Mg, Mo or W or an alloy thereof, graphite, graphene, or carbon nanotube.

In some embodiments, the second electrode is typically an organic, inorganic, or organic-inorganic hybrid conductive material, including Ag, Cu, C, Au, Al, ITO, AZO, BZO, or IZO.

In some embodiments, the second electrode is typically an organic, inorganic, or organic-inorganic hybrid conductive material, including Cu, Ag, Au, or a combination thereof.

In some embodiments, a thickness of the second electrode is 20-200 nm.

In some embodiments, a thickness of the second electrode is 60-100 nm.

In some embodiments, a thickness of the second electrode is 70-90 nm.

In some embodiments, a hole blocking layer may be present between the second electrode and the electron transport layer, and used to prevent reaction between the second electrode and perovskite, and avoid reduction in device efficiency caused by Schottky contact between the electron transport layer and a back electrode, and may have a function of regulating an energy level.

In some embodiments, a material of the hole blocking layer includes 2,9-dimethyl-4,7-diphenyl-1,10-phenanthroline (BCP, also known as bathocuproine), calcium acetylacetonate, LiF, aluminum 8-hydroxyquinoline, 1,3,5-tris(1-phenyl-1H-benzimidazol-2-yl)benzene, or a combination thereof.

In some embodiments, a material of the hole blocking layer includes BCP.

In some embodiments, a thickness of the hole blocking layer is 0. 1-30 nm.

In some embodiments, a thickness of the hole blocking layer is 3-10 nm.

In some embodiments, a thickness of the hole blocking layer is 4-6 nm.

In some embodiments, a passivation layer may be present between the perovskite layer and the electron transport layer, and used to passivate a defect on an interface therebetween.

In some embodiments, a passivation layer may be present between the electron transport layer and an electrode, so as to improve performance of the perovskite battery.

In some embodiments, the perovskite battery includes a first electrode, a hole transport layer, a perovskite layer, an electron transport layer, a hole blocking layer, and a second electrode that are stacked sequentially, where the hole transport layer includes a body layer and a surface layer disposed on a side of the body layer close to the perovskite layer. The first electrode is, for example, selected from FTO. A material of the body layer includes, for example, nickel oxide. A material of the surface layer includes, for example, nickel oxide. A material of the electron transport layer includes, for example, C60. A material of the hole blocking layer includes, for example, BCP. A material of the second electrode includes, for example, Cu.

In some embodiments, with reference to FIG. 1, a perovskite battery 10 includes FTO 1, a nickel oxide body layer 2, a nickel oxide surface layer 3, a perovskite layer 4, C60 5, BCP 6, and Cu 7 that are stacked sequentially, where FTO is the first electrode, C60 is the electron transport layer, BCP is the hole blocking layer, and Cu is the second electrode.

A second aspect of this application provides a method for preparing the perovskite battery according to the first aspect of this application, including:
(1) providing a first electrode;
(2) preparing a hole transport layer on the first electrode;
(3) preparing a perovskite layer on the hole transport layer;
(4) preparing an electron transport layer on the perovskite layer; and
(5) preparing a second electrode on the electron transport layer to obtain the perovskite battery,
where the hole transport layer includes a body layer and a surface layer disposed on a side of the body layer close to the perovskite layer; the hole transport layer includes nickel oxide containing trivalent nickel ions; and an atomic percentage of trivalent nickel ions in the surface layer is less than an atomic percentage of trivalent nickel ions in the body layer.

The method of this application has lower costs and is simple to operate, thereby facilitating large-scale industrial application.

In some embodiments of this application, step (2) includes preparing the hole transport layer on the first electrode according to a magnetron sputtering method using a nickel oxide target material. Therefore, the perovskite battery according to the first aspect of this application can be prepared more simply.

In some embodiments, in step (2), a nickel-to-oxygen ratio of the nickel oxide target material is 0.9-1.1.

In some embodiments of this application, a condition of the magnetron sputtering method includes: an argon-to-oxygen ratio used during preparation of the body layer being 500:( 1-200). Therefore, the perovskite battery according to the first aspect of this application can be prepared more simply.

In some embodiments, a condition of the magnetron sputtering method includes: an argon-to-oxygen ratio used during preparation of the body layer being 500:( 1-100). Therefore, the perovskite battery according to the first aspect of this application can be prepared more simply.

In some embodiments, a condition of the magnetron sputtering method includes: an argon-to-oxygen ratio used during preparation of the body layer being 500:(3-100). Therefore, the perovskite battery according to the first aspect of this application can be prepared more simply.

In some embodiments, a condition of the magnetron sputtering method includes: an argon-to-oxygen ratio used during preparation of the body layer being 500:(30-70). Therefore, the perovskite battery according to the first aspect of this application can be prepared more simply.

In some embodiments of this application, the condition of the magnetron sputtering method includes: an argon-to-oxygen ratio used during preparation of the surface layer being higher than the argon-to-oxygen ratio used during preparation of the body layer. Therefore, the perovskite battery according to the first aspect of this application can be prepared more simply.

In some embodiments of this application, the condition of the magnetron sputtering method includes: during preparation of the surface layer, different argon-to-oxygen ratios being used during preparation of different gradients, so as to obtain the gradients with different atomic percentages of trivalent nickel ions.

In some embodiments of this application, the condition of the magnetron sputtering method includes: argon-to-oxygen ratios used during preparation of different gradients along the thickness direction of the surface layer from a side of the body layer to a side of the perovskite layer gradually increasing.

In some embodiments of this application, for example, step (2) includes preparing a nickel oxide layer via direct current magnetron sputtering, where an argon-to-oxygen ratio during sputtering of the body layer is 500/5; an argon-to-oxygen ratio changes every 2 nm during sputtering of the surface layer; and an argon-to-oxygen ratio for a first 2 nm is 500/4, an argon-to-oxygen ratio for a second 2 nm is 500/3, ..., an argon-to-oxygen ratio for a fifth 2 nm (namely, the outermost gradient) is 500/0, and so on.

In some embodiments, step (1) includes disposing a transparent conductive oxide layer on the transparent substrate layer, so as to obtain the first electrode attached to the transparent substrate layer. Alternatively, the first electrode attached to the transparent substrate layer may be a commercially available product.

In some embodiments, in step (1), the transparent substrate layer (for example, conductive glass) may be further cleaned, for example, be cleaned via ultrasonic cleaning with water, acetone, and isopropanol sequentially, for example, for 1-30 minutes, then dried, and further cleaned in an ultraviolet ozone machine, for example, for 1-20 minutes.

In some embodiments, step (3) includes coating a perovskite precursor solution onto the hole transport layer, then performing pre-drying according to a vacuum pumping method, followed by annealing, for example, at a temperature of 80-120°C for 20-40 minutes, and performing cooling to obtain the perovskite layer. The coating method may be spin coating, blade coating, slot-die coating, spraying, or the like.

In some embodiments, the perovskite precursor solution used in step (3) is prepared according to the following steps: dissolving a perovskite precursor material (for example, at least one of formamidinium iodide, lead iodide, methylammonium bromide, methylammonium iodide, cesium iodide, lead bromide, or the like) in a solvent (for example, dimethylformamide (DMF), dimethyl sulfoxide (DMSO), or N-methyl pyrrolidone (NMP)), and performing uniform stirring and filtering sequentially to obtain the perovskite precursor solution.

In some embodiments, the second electrode is prepared in step (5). Preparation of the second electrode may be performed using a conventional method in the art. For example, the electrode may be prepared via evaporation.

In some embodiments, the electron transport layer may be prepared before step (5). The electron transport layer is prepared using a conventional technical means in the art. For example, the electron transport layer may be prepared via spin coating, evaporation, or the like.

A third aspect of this application provides an electric apparatus, including the perovskite battery according to the first aspect of this application, or a perovskite battery prepared according to the method according to the second aspect of this application, where the perovskite battery is used to supply power to the electric apparatus.

In some embodiments, the electric apparatus is a common device including the perovskite battery of this application, for example, a device used in the fields of communication, transportation, industry and agriculture, lighting, or the like. The electric apparatus may include, for example, a satellite, a communication device, traffic lights, a lighthouse, a wireless telephone booth, a monitoring device used in the drilling field, a power system, a camping light, an electric vehicle, an electronic device charger, or the like.

### Examples

The following describes the examples of this application. The examples described below are exemplary and are intended only to explain this application and should not be construed as limiting this application. Examples whose specific techniques or conditions are not specified were performed in accordance with techniques or conditions described in documents in the field or in accordance with product instructions. All used reagents or instruments without specified manufacturers are commercially available conventional products.

### I. Perovskite battery

### Example 1

(1) Twenty pieces of FTO conductive glass with a specification of 2.0*2.0 cm were taken; 0.35 cm of FTO was removed from two ends via laser etching to expose a glass substrate; the FTO conductive glass was ultrasonically cleaned for 10 minutes (min) each sequentially with 500 milliliters (mL) of water, acetone, and isopropanol; and then, the cleaned FTO conductive glass was dried with a nitrogen gun to remove a solvent, and was further cleaned in an ultraviolet ozone machine for 5 min to obtain a first electrode.
(2) A nickel oxide target material with a nickel-to-oxygen ratio of 1:1 was used on the first electrode, followed by magnetron sputtering, under a sputtering power of 2000 watts (W), a body layer with a thickness of 12 nm at an argon-to-oxygen ratio of 500:50, and magnetron sputtering a surface layer at an argon-to-oxygen ratio of 500:3.
(3) 1362 milligrams (mg) of formamidinium hydroiodide (FAI), 228.6 mg of cesium iodide (CsI), and 4056.9 mg of lead iodide (PbI₂) were dissolved in 8 mL of a solvent to prepare a perovskite precursor solution with a molar concentration of 1.1 moles per liter (mol/L), where the solvent was a mixture of DMF (N,N-dimethylformamide) and NMP (N-methyl pyrrolidone) in a volume ratio of 7:1.
   The precursor solution was coated onto a nickel oxide layer; then, the sample was transferred to a vacuum chamber and allowed to stand under a vacuum of 100 pascals (Pa) or less for 120 seconds (s) to solidify the precursor solution into a film; the solidified sample was placed on a hot stage for annealing treatment at a temperature of 150 degrees Celsius (°C) for 30 min; and after the annealing treatment, a perovskite layer with a thickness of 500 nm was obtained.
(4) PC₆₁BM was spin-coated onto the perovskite layer obtained in step (3) at 1500 revolutions per minute per second (rpm/s), and then annealed at 100°C for 10 min, to obtain an electron transport layer with a thickness of 50 nm; and subsequently, a solution of BCP in isopropanol with a concentration of 0.5 milligrams per milliliter (mg/mL) was spin-coated onto the electron transport layer at 5000 rpm/s to obtain a hole blocking layer with a thickness of 5 nm.
(5) The device obtained in step (5) was placed in an LN-F300 thermal evaporator, and a metal electrode Cu was evaporated onto the hole blocking layer under a vacuum condition of 10⁻⁵ Pa to prepare a second electrode layer with a thickness of 80 nm; and the perovskite battery was obtained.

### Example 2

Steps of Example 1 were repeated, except that: in step (2), a surface layer of a first 2-nm gradient was sputtered at an argon-to-oxygen ratio of 500:30, and a 2-nm outermost layer was sputtered at an argon-to-oxygen ratio of 500:5.

### Example 3

Steps of Example 1 were repeated, except that: in step (2), a surface layer of a first 2-nm gradient was sputtered at an argon-to-oxygen ratio of 500:39, a surface layer of a second 2-nm gradient was sputtered at an argon-to-oxygen ratio of 500:25, and a 2-nm outermost layer was sputtered at an argon-to-oxygen ratio of 500:5.

### Example 4

Steps of Example 1 were repeated, except that: in step (2), a surface layer of a first 2-nm gradient was sputtered at an argon-to-oxygen ratio of 500:41, a surface layer of a second 2-nm gradient was sputtered at an argon-to-oxygen ratio of 500:30, a surface layer of a third 2-nm gradient was sputtered at an argon-to-oxygen ratio of 500:16, and a 2-nm outermost layer was sputtered at an argon-to-oxygen ratio of 500:5.

### Example 5

Steps of Example 1 were repeated, except that: in step (2), a surface layer of a first 2-nm gradient was sputtered at an argon-to-oxygen ratio of 500:43, a surface layer of a second 2-nm gradient was sputtered at an argon-to-oxygen ratio of 500:35, a surface layer of a third 2-nm gradient was sputtered at an argon-to-oxygen ratio of 500:25, a surface layer of a fourth 2-nm gradient was sputtered at an argon-to-oxygen ratio of 500:16, and a 2-nm outermost layer was sputtered at an argon-to-oxygen ratio of 500:5.

### Example 6

Steps of Example 1 were repeated, except that: in step (2), a surface layer of a first 2-nm gradient was sputtered at an argon-to-oxygen ratio of 500:45, a surface layer of a second 2-nm gradient was sputtered at an argon-to-oxygen ratio of 500:39, a surface layer of a third 2-nm gradient was sputtered at an argon-to-oxygen ratio of 500:32, a surface layer of a fourth 2-nm gradient was sputtered at an argon-to-oxygen ratio of 500:25, a surface layer of a fifth 2-nm gradient was sputtered at an argon-to-oxygen ratio of 500:16, and a 2-nm outermost layer was sputtered at an argon-to-oxygen ratio of 500:5.

### Example 7

Steps of Example 6 were repeated, except that: in step (2), a thickness of the body layer was 10 nm.

### Example 8

Steps of Example 6 were repeated, except that: in step (2), a thickness of the body layer was 30 nm.

### Example 9

Steps of Example 1 were repeated, except that: in step (2), a 12-nm body layer was sputtered at an argon-to-oxygen ratio of 500:30, a surface layer of a first 2-nm gradient was sputtered at an argon-to-oxygen ratio of 500:25, a surface layer of a second 2-nm gradient was sputtered at an argon-to-oxygen ratio of 500:20, a surface layer of a third 2-nm gradient was sputtered at an argon-to-oxygen ratio of 500:14, a surface layer of a fourth 2-nm gradient was sputtered at an argon-to-oxygen ratio of 500:10, and a 2-nm outermost layer was sputtered at an argon-to-oxygen ratio of 500:5.

### Example 10

Steps of Example 1 were repeated, except that: in step (2), a 12-nm body layer was sputtered at an argon-to-oxygen ratio of 500:60, a surface layer of a first 2-nm gradient was sputtered at an argon-to-oxygen ratio of 500:50, a surface layer of a second 2-nm gradient was sputtered at an argon-to-oxygen ratio of 500:41, a surface layer of a third 2-nm gradient was sputtered at an argon-to-oxygen ratio of 500:30, a surface layer of a fourth 2-nm gradient was sputtered at an argon-to-oxygen ratio of 500:16, and a 2-nm outermost layer was sputtered at an argon-to-oxygen ratio of 500:5.

### Examples 11 and 12

Steps of Example 10 were repeated, except that: a thickness of the body layer and an atomic percentage of trivalent nickel ions were changed.

### Example 13

Steps of Example 2 were repeated, except that: in step (2), a 2-nm outermost layer was sputtered at an argon-to-oxygen ratio of 500:0.

### Example 14

Steps of Example 2 were repeated, except that: in step (2), a 2-nm outermost layer was sputtered at an argon-to-oxygen ratio of 500:1.

### Example 15

Steps of Example 2 were repeated, except that: in step (2), a 2-nm outermost layer was sputtered at an argon-to-oxygen ratio of 500:16.

### Examples 16 to 19

Steps of Example 2 were repeated, except that: a thickness of the first gradient layer and a thickness of the outermost layer were changed.

Comparative Example 1: The hole transport layer did not include any surface layer.

Steps of Example 1 were repeated, except that: preparation of the surface layer in step (2) was not performed.

### Comparative Example 2

Steps of Example 1 were repeated, except that: a 2-nm outermost layer was sputtered at an argon-to-oxygen ratio of 500:30.

Product parameters of the perovskite batteries obtained in the above examples and comparative examples are shown in Table 1.

### Parameter tests

Tests for quantities of atoms of divalent nickel ions and trivalent nickel ions in a hole transport layer and an interface passivation layer

Atoms of divalent nickel ions and trivalent nickel ions in a body layer and a surface layer of the hole transport layer were quantified via X-ray photoelectron spectroscopy (XPS) using a K-Alpha spectrometer (manufacturer: Thermo Fisher), where

Atomic percentage of divalent or trivalent nickel ions = Quantity of atoms of divalent or trivalent nickel ions/Total quantity of atoms of all nickel ions in a layer or gradient where the ions are located.

A represents an atomic percentage of trivalent nickel ions in the layer or gradient.

**Table 1 Product parameters of perovskite batteries in examples and comparative examples**

| Number | Bulk layer | Bulk layer | Surface layer | Surface layer | Surface layer | Surface layer | Surface layer | Surface layer |
|---|---|---|---|---|---|---|---|---|
| Number | Thickness (nm) | A | Gradient 1 thickness and A | Gradient 2 thickness and A | Gradient 3 thickness and A | Gradient 4 thickness and A | Gradient 5 thickness and A | Outermost thickness and A |
| Example 1 | 12 | 30% | / | / | / | / | / | 2nm 10% |
| Example 2 | 12 | 30% | 2nm 20% | / | / | / | / | 2nm 10% |
| Example 3 | 12 | 30% | 2nm 24% | 2nm 18% | / | / | / | 2nm 10% |
| Example 4 | 12 | 30% | 2nm 25% | 2nm 20% | 2nm 15% | / | / | 2nm 10% |
| Example 5 | 12 | 30% | 2nm 26% | 2nm 22% | 2nm 18% | 2nm 15% | / | 2nm 10% |
| Example 6 | 12 | 30% | 2nm 27% | 2nm 24% | 2nm 21% | 2nm 18% | 2nm 15% | 2nm 10% |
| Example 7 | 10 | 30% | 2nm 27% | 2nm 24% | 2nm 21% | 2nm 18% | 2nm 15% | 2nm 10% |
| Example 8 | 30 | 30% | 2nm 27% | 2nm 24% | 2nm 21% | 2nm 18% | 2nm 15% | 2nm 10% |
| Example 9 | 12 | 20% | 2nm 18% | 2nm 16% | 2nm 14% | 2nm 12% | / | 2nm 10% |
| Example 10 | 12 | 35% | 2nm 30% | 2nm 25% | 2nm 20% | 2nm 15% | / | 2nm 10% |
| Example 11 | 12 | 65% | 2nm 30% | 2nm 25% | 2nm 20% | 2nm 15% | / | 2nm 10% |
| Example 12 | 40 | 35% | 2nm 30% | 2nm 25% | 2nm 20% | 2nm 15% | / | 2nm 10% |
| Example 13 | 12 | 30% | 2nm 20% | / | / | / | / | 2nm 1% |
| Example 14 | 12 | 30% | 2nm 20% | / | / | / | / | 2nm 5% |
| Example 15 | 12 | 30% | 2nm 20% | / | / | / | / | 2nm 15% |
| Example 16 | 12 | 30% | 0.5nm 20% | / | / | / | / | 2nm10% |
| Example 17 | 12 | 30% | 4nm 20% | / | / | / | / | 2nm10% |
| Example 18 | 12 | 30% | 2nm 20% | / | / | / | / | 0.5nm10% |
| Example 19 | 12 | 30% | 2nm 20% | / | / | / | / | 4nm10% |
| Comparative Example 1 | 12 | 30% | / | / | / | / | / | / |
| Comparative Example 2 | 12 | 30% | / | / | / | / | / | 2nm 20% |

### II. Performance tests for perovskite batteries

### 1. Tests for photoelectric conversion efficiency

Tests were performed according to the national standard IEC61215, where the tests were performed under illumination using a Keithley 2400 digital source meter, with a light source provided by a solar simulator equipped with a 450W xenon lamp having an ultraviolet filter, and light emitted by the light source conformed to the AM 1.5G standard solar spectrum. A battery was connected to the digital source meter. Photoelectric conversion efficiency was measured under illumination.

The perovskite batteries obtained in the above examples and comparative examples were tested according to the above procedure. For specific values, refer to Table 2.

**Table 2 Photoelectric conversion efficiency of perovskite batteries in examples and comparative examples**

| Number | Battery efficiency (%) |
|---|---|
| Example 1 | 15 |
| Example 2 | 15.4 |
| Example 3 | 15.6 |
| Example 4 | 16 |
| Example 5 | 16.5 |
| Example 6 | 15.7 |
| Example 7 | 15.1 |
| Example 8 | 14.3 |
| Example 9 | 13.2 |
| Example 10 | 16.8 |
| Example 11 | 17 |
| Example 12 | 13 |
| Example 13 | 15.9 |
| Example 14 | 15.7 |
| Example 15 | 12.9 |
| Example 16 | 15.5 |
| Example 17 | 14.8 |
| Example 18 | 15 |
| Example 19 | 14 |
| Comparative Example 1 | 12 |
| Comparative Example 2 | 12.3 |

It can be learned from Table 1 and Table 2 that the efficiency of the perovskite batteries of this application all achieved excellent technical effects, where the efficiency of the perovskite batteries in Examples 1 to 16 reached 12.9% or higher, and the efficiency of the perovskite batteries in Examples 1 to 7, Examples 10 and 11, Examples 13 and 14, and Example 16 reached 15% or higher.

The technical features of the above-described examples may be arbitrarily combined. To keep the description concise, not all possible combinations of the technical features in the above examples are described. However, a combination of these technical features should be considered within the scope of this specification, as long as there is no contradiction in this combination.

The above-described examples merely express several embodiments of this application, with relatively specific and detailed descriptions, but should not be construed as limiting the scope of this application. It should be noted that, for a person of ordinary skill in the art, several variations and improvements may be made without departing from the concept of this application, all of which fall within the protection scope of this application. Therefore, the protection scope of this application should be subject to the appended claims, and the specification and accompanying drawings may be used to interpret the content of the claims.

## Claims

1. A perovskite battery, comprising a first electrode, a hole transport layer, a perovskite layer, an electron transport layer, and a second electrode that are arranged sequentially, wherein the hole transport layer comprises a body layer and a surface layer disposed on a side of the body layer close to the perovskite layer; the hole transport layer comprises nickel oxide containing trivalent nickel ions; and an atomic percentage of trivalent nickel ions in the surface layer is less than an atomic percentage of trivalent nickel ions in the body layer.

2. The perovskite battery according to claim 1, wherein the atomic percentage of the trivalent nickel ions in the surface layer decreases in a gradient manner along a thickness direction of the surface layer from a side close to the body layer to a side away from the body layer.

3. The perovskite battery according to claim 2, wherein the atomic percentage of the trivalent nickel ions decreases along the thickness direction of the surface layer with a gradient of 0.5-4 nm.

4. The perovskite battery according to claim 2 or 3, wherein a difference between atomic percentages of trivalent nickel ions in two adjacent gradients is 2-20%.

5. The perovskite battery according to any one of claims 2 to 4, wherein an atomic percentage of trivalent nickel ions in an outermost gradient of the surface layer in direct contact with the perovskite layer is 1-15%.

6. The perovskite battery according to any one of claims 1 to 5, wherein the atomic percentage of the trivalent nickel ions in the body layer is 20-65%.

7. The perovskite battery according to any one of claims 1 to 6, wherein the perovskite battery has one or both of the following features:
(1) a thickness of the surface layer being 2-15 nm; and
(2) a thickness of the body layer being 10-40 nm.

8. A method for preparing a perovskite battery, comprising:
(1) providing a first electrode;
(2) preparing a hole transport layer on the first electrode;
(3) preparing a perovskite layer on the hole transport layer;
(4) preparing an electron transport layer on the perovskite layer; and
(5) preparing a second electrode on the electron transport layer to obtain the perovskite battery,
wherein the hole transport layer comprises a body layer and a surface layer disposed on a side of the body layer close to the perovskite layer; the hole transport layer comprises nickel oxide containing trivalent nickel ions; and an atomic percentage of trivalent nickel ions in the surface layer is less than an atomic percentage of trivalent nickel ions in the body layer.

9. The method according to claim 8, wherein step (2) comprises preparing the hole transport layer on the first electrode according to a magnetron sputtering method.

10. The method according to claim 9, wherein a condition of the magnetron sputtering method comprises: an argon-to-oxygen ratio used during preparation of the body layer being 500:( 1-200).

11. The method according to claim 9 or 10, wherein the condition of the magnetron sputtering method comprises: an argon-to-oxygen ratio used during preparation of the surface layer being higher than the argon-to-oxygen ratio used during preparation of the body layer.

12. An electric apparatus, comprising the perovskite battery according to any one of claims 1 to 7, or a perovskite battery prepared according to the method according to any one of claims 8 to 11, wherein the perovskite battery is used to supply power to the electric apparatus.
